(19) Europäisches Patentamt
European Patent Office
Office européen des brevets

(11) **EP 1 952 170 B1**

## (12) FASCICULE DE BREVET EUROPEEN

(45) Date de publication et mention
de la délivrance du brevet:
**05.12.2012 Bulletin 2012/49**

(21) Numéro de dépôt: **06831307.1**

(22) Date de dépôt: **26.10.2006**

(51) Int Cl.:
**G01R 33/421** *(2006.01)*     **G01R 33/385** *(2006.01)*

(86) Numéro de dépôt international:
**PCT/FR2006/051115**

(87) Numéro de publication internationale:
**WO 2007/048983 (03.05.2007 Gazette 2007/18)**

(54) **MACHINE DE RMN A BOBINES DE GRADIENT SOLENOIDALES**

NMR-MASCHINE MIT ELEKTROMAGNETISCHEN GRADIENTENSPULEN

NMR MACHINE COMPRISING SOLENOID GRADIENT COILS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **26.10.2005 FR 0510950**

(43) Date de publication de la demande:
**06.08.2008 Bulletin 2008/32**

(73) Titulaire: **Commissariat à l'Énergie Atomique et aux Énergies Alternatives
75015 Paris (FR)**

(72) Inventeur: **AUBERT, Guy
F-86000 Poitiers (FR)**

(74) Mandataire: **Thévenet, Jean-Bruno et al
Cabinet Beau de Loménie
158, rue de l'Université
75340 Paris Cédex 07 (FR)**

(56) Documents cités:
**EP-A- 1 286 173     WO-A-2005/029110
US-A- 5 530 355     US-A- 5 764 059**

**Description**

La présente invention concerne une machine de résonance magnétique nucléaire (RMN) à bobines à gradient solénoïdales incorporées dans des tubes à accessibilité améliorée, et plus particulièrement une machine de RMN à compensation des courants de Foucault engendrés par les bobines de gradient.

L'invention concerne d'une manière générale une machine de RMN utilisable pour réaliser de l'imagerie par résonance magnétique (IRM) notamment dans le domaine médical.

Des machines de RMN peuvent présenter une structure du type tunnel avec un espace central réservé au patient et une structure annulaire qui doit intégrer d'une part des moyens pour créer dans l'espace central d'observation un champ magnétique principal intense $B_0$, ces moyens étant généralement constitués par une bobine supraconductrice d'aimantation principale disposée dans un cryostat, ou le cas échéant par un aimant permanent, et d'autre part des moyens d'excitation radiofréquence (antennes d'émission) et de traitement des signaux radiofréquence réémis par le corps d'un patient placé dans l'espace central d'observation, en réponse aux séquence d'excitation radiofréquence.

Pour pouvoir différencier les signaux radiofréquence émis en réponse et créer une image, il est en outre mis en oeuvre des bobines, dites bobines de gradient, pour superposer au champ homogène intense principal, des champs magnétiques supplémentaires dont la valeur est fonction des coordonnées dans l'espace de leur lieu d'application.

On organise traditionnellement cette différenciation selon trois axes orthogonaux X, Y, Z, avec l'axe Z qui est généralement pris colinéaire au champ intense $B_0$. Chaque lieu de l'espace peut ainsi être codé à une valeur de champ différente et on exploite dans le signal réémis les modifications qui en résultent pour créer l'image.

L'acquisition d'une image nécessite donc, au cours de l'application des séquences d'excitation radiofréquence, l'application conjointe de séquences de gradient de champ. Quelle que soit la méthode d'imagerie retenue, une caractéristique des gradients de champ est qu'ils sont pulsés.

Divers exemples de systèmes de bobines de gradient pour machines de RMN ont été donnés par exemple dans les documents de brevet FR 2 588 997 et FR 2 621 125. Pour que l'imagerie RMN soit de qualité, il convient que les gradients de champ réels soient homogènes, c'est-à-dire respectent, avec une tolérance donnée, une distribution théorique idéale que l'on voudrait imposer. Pour accroître l'homogénéité des gradients produits, les bobines de gradient doivent être les plus grandes possibles, mais il convient également, pour des questions d'encombrement et de puissance, de ne pas augmenter exagérément la taille de ces bobines de gradient dont la conception est donc soumise à des exigences contradictoires. '

Par ailleurs, le caractère temporaire des impulsions de gradient nécessite de résoudre en plus d'un problème de linéarité du champ que ces bobines de gradient procurent, des problèmes liés au caractère pulsé de ce champ.

Ainsi, en particulier, pour des machines de RMN à champ orientateur de forte intensité, il est nécessaire d'avoir des signaux de RMN détectables de fréquence élevée, par exemple de l'ordre de 426 MHz pour des machines de RMN fonctionnant à environ 10 teslas. Les bobines de gradient doivent alors être à même de fournir une pente de gradient par exemple de l'ordre de 100 à 150 milliteslas par mètre.

De tels gradients plus puissants conduisent à plusieurs types de problèmes. Premièrement, la puissance dissipée par les bobines de gradient capables de telles pentes devient très importante : de l'ordre de quelques dizaines de kW. Il convient donc de mettre en place un refroidissement efficace pour que ces gradients ne viennent pas réchauffer le patient et le cryostat dans lequel est contenue la bobine supraconductrice d'aimantation principale.

En outre, dan des séquences d'imagerie utilisées actuellement, des séquences rapides comportent l'application d'impulsions de gradient dont la durée est de l'ordre de quelques millisecondes et dont les temps de montée et de descente doivent être inférieurs ou égaux à la milliseconde.

Avec les puissances électriques mises en jeu, les bobines de gradient se retrouvent alors soumises, dans le champ orienteur de la machine, à des accélérations très violentes dues aux forces électromagnétiques. Ces accélérations provoquent d'une part à court terme la détérioration de la machine et d'autre part la production de bruits insupportables par le patient sous examen. La contrainte de bruit est par ailleurs une contrainte particulièrement néfaste lorsque, notamment dans le cadre de l'examen du cerveau, on cherche à mettre en évidence les zones du cerveau qui sont sollicitées lors d'un exercice intellectuel particulier. Il est alors difficile de demander à un patient de se livrer à un exercice intellectuel particulier (par exemple effectuer des opérations d'addition ou de multiplication mentalement) tout en le soumettant à un bruit trépidant qui gêne sa concentration.

Quand bien même ce type d'expérience serait envisageable avec un être humain, les expériences pré-cliniques effectuées avec des animaux ne sont alors pas possibles si ces animaux sont sollicités par ailleurs par ces bruits.

L'ensemble de ces problèmes doit bien entendu être résolu en tenant compte du fait que l'encombrement des bobines de gradient est limité, pour laisser un volume d'examen utile suffisamment grand. A titre indicatif, on retiendra parce que c'est maintenant une habitude dans le domaine, que le volume utile d'examen se situe dans un tunnel de section circulaire dont le diamètre doit avoir une valeur d'environ 550 millimètres, les bobines de gradient devant tenir dans un espace annulaire compris entre ce volume tunnel utile et le volume à l'intérieur des enveloppes du cryostat. Ce volume intérieur au cryostat dégage un tunnel circulaire d'environ 1000 millimètres de diamètre.

Pour réaliser des gradients tout en prenant en compte les problèmes précédents, on a déjà proposé, dans le document de brevet WO2005/029110, de consacrer l'espace annulaire disponible à la mise en place de tubes dans lesquels sont engagées des bobines solénoïdales circulaires. De préférence, les tubes sont contigus les uns aux autres et forment une nappe de tubes.

La disposition des bobines dans les tubes permet d'aboutir au résultat escompté de grande intensité des gradients produits grâce à des possibilités de refroidissement améliorées, de respect des contraintes de linéarité imposées par les spécifications, de réduction des bruits acoustiques et dans une certaine mesure de limitation des courants de Foucault.

La disparition des bruits provient de la structure solénoïdale des bobines engagées dans des tubes d'axes parallèles au champ principal et de leurs sollicitations uniquement radiales à leur propre structure, le torseur résultant des contraintes électromagnétiques étant nul.

Les structures ainsi préconisées, notamment pour les gradients X et Y, ayant une orientation de champ perpendiculaire aux bobines de gradient classiques produisent dans les écrans ou les différentes enveloppes métalliques du cryostat des courants de Foucault notablement plus faibles que selon les réalisations précédemment connues.

Toutefois, ces courants de Foucault peuvent dans certains cas rester gênants, notamment en provoquant un échauffement exagéré du cryostat, qui augmente la consommation de fluide cryogénique.

Par ailleurs, l'interposition d'écrans classiques entre des générateurs de gradients et le cryostat de l'aimant principal permet de diminuer à l'extérieur de ces écrans les champs électriques produits par les générateurs de gradients.

Toutefois, cette réduction des courants induits diminue l'efficacité des gradients et rend encore plus difficile la réalisation de gradients intenses à commutation rapide dans un champ principal élevé.

On connaît encore par le document de brevet US 5 530 355 une machine de RMN dans laquelle, pour réaliser des gradients, on utilise également des bobinages dont les axes sont des génératrices d'un cylindre dont l'axe correspond à la direction du champ magnétique principal. Pour améliorer la linéarité, le document précité préconise cependant d'utiliser des bobinages autres que solénoïdaux, ce qui rend la réalisation plus complexe.

Le document de brevet US 5 764 059 décrit par ailleurs un exemple d'écran acoustique et magnétique utilisable dans des machines d'imagerie par résonance magnétique en association avec des structures de production de gradients classiques avec des bobines en forme de selle de cheval pour les gradients x et y et des spires de Maxwell pour le gradient z. Dans ce cas, comme il convient de mettre à la fois des bobines de gradient x et des bobines de gradient y, la présence de ces bobines sur un même mandrin général conduit à restreindre l'espace disponible pour chacun de ces deux jeux de bobines à deux secteurs cylindriques d'ouverture $\pi/2$ à chaque fois, ce qui en pratique empêche d'obtenir la linéarité souhaitée pour les gradients.

L'invention a pour but de remédier aux inconvénients précités et notamment d'améliorer l'accessibilité à une machine de RMN, en particulier dans le cas d'imagerie du cerveau au cours de laquelle on procède à des observations de la seule tête d'un patient, à l'aide d'un système dit "gradient tête" dont les dimensions sont bien inférieures à celles des examens d'imagerie par résonance magnétique (IRM) pratiqués sur le corps entier d'un patient.

L'invention a encore pour objet de diminuer les inconvénients liés à la création de courants de Foucault par les générateurs de gradients.

Ces buts sont atteints, conformément à l'invention, grâce à une machine de résonance magnétique nucléaire comprenant des moyens de création d'un champ magnétique principal intense $B_0$ dans un espace intérieur utile en forme de tunnel d'axe Z, des moyens d'excitation radiofréquence et de traitement des signaux radiofréquence émis en réponse par un corps ou objet disposé dans ledit espace intérieur utile, et un premier ensemble de bobines de gradient solénoïdales pour superposer au champ magnétique intense $B_0$ des composants d'un champ magnétique supplémentaire, lesdites bobines de gradient étant incorporées dans des tubes disposés de façon parallèle à l'axe Z dans un espace annulaire cylindrique situé entre une enceinte cryogénique extérieure contenant lesdits moyens de création d'un champ magnétique intense $B_0$ et ledit espace intérieur utile, le diamètre des bobines de gradient étant inscrit dans une épaisseur dudit espace annulaire cylindrique, les bobines de gradient solénoïdales du premier ensemble étant adaptées pour produire à la fois un premier gradient de champ X dans une première direction x radiale de la machine perpendiculaire à l'axe Z, et un deuxième gradient de champ Y dans une deuxième direction y radiale de la machine également perpendiculaire à l'axe Z, la première direction x étant perpendiculaire à la deuxième direction y, et la machine comportant des amplificateurs pour alimenter simultanément ces bobines solénoïdales par des sommes algébriques de courants correspondant aux deux gradients, caractérisée en ce que l'espace annulaire cylindrique comporte sur une paroi externe de celui-ci des bobines annulaires de production d'un gradient de champ magnétique orienté parallèlement à la direction du champ magnétique principal $B_0$ tandis que les bobines solénoïdales produisant des gradients de champ X et Y dans des directions perpendiculaires à la direction Z du champ magnétique principal $B_0$ sont toutes disposées dans l'épaisseur de l'espace annulaire cylindrique, et en ce que les bobines de gradients solénoïdales incorporées dans des tubes constituent des sources élémentaires de gradients de champ X et Y dans des directions perpendiculaires à la direction de l'axe Z, qui sont dimensionnées comme faisant partie d'un ensemble de N sources élémentaires contiguës réparties selon le pourtour de l'espace annulaire cylindrique, où $N = 4\upsilon + 2$, $\upsilon$ étant un entier supérieur ou égal à 1, mais où deux sources élémentaires diamétralement opposées correspondant à un plan axial xOz sont omises pour ne conserver que 4υ sources élémentaires contiguës réparties en deux sous-ensembles séparés par des espaces libres, chaque tube étant muni d'une source élémentaire.

La machine peut en outre comprendre entre ladite enceinte cryogénique extérieure et ledit espace annulaire cylindrique un espace annulaire cylindrique supplémentaire dans lequel est disposé un deuxième ensemble de bobines de gradient solénoïdales qui sont incorporées dans des tubes disposés de façon parallèle à l'axe Z et le sens de circulation des courants pulsés dans les bobines de gradient solénoïdales dudit deuxième ensemble est inversé par rapport au sens de circulation des courants pulsés dans les bobines de gradient solénoïdales dudit premier ensemble de manière à créer des gradients de champ en sens inverse qui réduisent le potentiel vecteur et les courants de Foucault induits dans l'enceinte cryogénique extérieure.

Le nombre des bobines de gradient solénoïdales du deuxième ensemble peut être identique au nombre de bobines de gradient solénoïdales du premier ensemble, mais ceci n'est pas obligatoire et ce nombre peut également être différent.

Grâce à la compensation opérée par le deuxième ensemble de bobines disposé en couronne de façon concentrique autour du premier ensemble de bobines, on réduit le potentiel vecteur magnétique généré dans les conducteurs environnants, et notamment dans les parois du cryostat de l'aimant principal, sans diminuer de façon pénalisante le gradient de champ produit par le premier ensemble de bobines dans le volume utile où se trouve le patient.

Selon un mode de réalisation particulier, l'espace annulaire cylindrique supplémentaire comporte sur une paroi externe de celui-ci des bobines annulaires de production d'un gradient de champ magnétique orienté selon la direction du champ magnétique principal $B_0$, tandis que les bobines solénoïdales produisant des gradients de champ X, Y dans des directions perpendiculaires à la direction z de ce champ magnétique principal sont toutes disposées dans l'épaisseur de l'espace annulaire cylindrique supplémentaire.

Selon un autre mode de réalisation possible, les bobines solénoïdales sont réparties selon le pourtour de l'espace annulaire ou de l'espace annulaire cylindrique supplémentaire en 2n arrangements de bobines solénoïdales coaxiales, plusieurs bobines étant alimentées simultanément par des combinaisons de courants pour produire un gradient X et/ou Y et/ou Z, n étant un entier supérieur ou égal à 3 et de préférence compris entre 4 et 9.

Selon une variante de réalisation, une composante d'un courant qui passe dans une bobine pour produire un gradient est proportionnelle à un courant nominal multiplié par un cosinus d'un angle de repérage de la bobine sur le pourtour de l'espace annulaire.

Selon une autre variante de réalisation, une composante d'un courant qui passe dans une bobine pour produire un gradient est proportionnelle à un courant nominal multiplié par un coefficient 1, 0,732 ou 0,268, en fonction d'un angle de repérage de la bobine sur le pourtour de l'espace annulaire.

Selon une réalisation particulière, l'espace annulaire comporte plusieurs tubes contigus répartis sur le pourtour pour recevoir les bobines solénoïdales, le rayon a d'un tube étant donné par a = r1(sinπ/N)/(1-sinπ/N) = r2(sinπ/N)/(1+sinπ/N), formule dans laquelle N représente le nombre de tubes et r1 et r2 les rayons intérieur et extérieur respectivement de l'espace annulaire.

Des bobines solénoïdales sont alimentées par des alimentations électriques individualisées.

Avantageusement, les bobines solénoïdales sont formées de spires, de préférence à profil rectangulaire, hélicoïdales allongées le long de manchons circulaires conducteurs, plusieurs manchons d'une même bobine étant concentriques et engagés les uns dans les autres.

Dans ce cas, de préférence, un espace annulaire entre deux manchons est parcouru par un fluide de refroidissement.

Ces caractéristiques peuvent s'appliquer aussi bien aux bobines de gradient solénoïdales du premier ensemble qu'aux bobines de gradient solénoïdales de compensation du deuxième ensemble.

D'autres caractéristiques et avantages de l'invention ressortiront de la description suivante de modes particuliers de réalisation, donnés à titre d'exemples en référence aux dessins annexés sur lesquels :

- la Figure 1 est une vue schématique en coupe longitudinale d'une machine de RMN,
- la Figure 2 est une vue schématique en coupe perpendiculaire à l'axe du tunnel et du champ principal, montrant une machine de RMN à laquelle est applicable l'invention,
- la Figure 3 est une vue schématique en coupe perpendiculaire à l'axe du tunnel d'une machine de RMN,
- la Figure 4 est une vue schématique en coupe perpendiculaire à l'axe du tunnel, d'une partie de machine de RMN selon l'invention, adaptée pour dégager des espaces libres localisés, et
- la Figure 5 est une vue schématique en perspective montrant un exemple d'application à un examen de "gradient de tête".

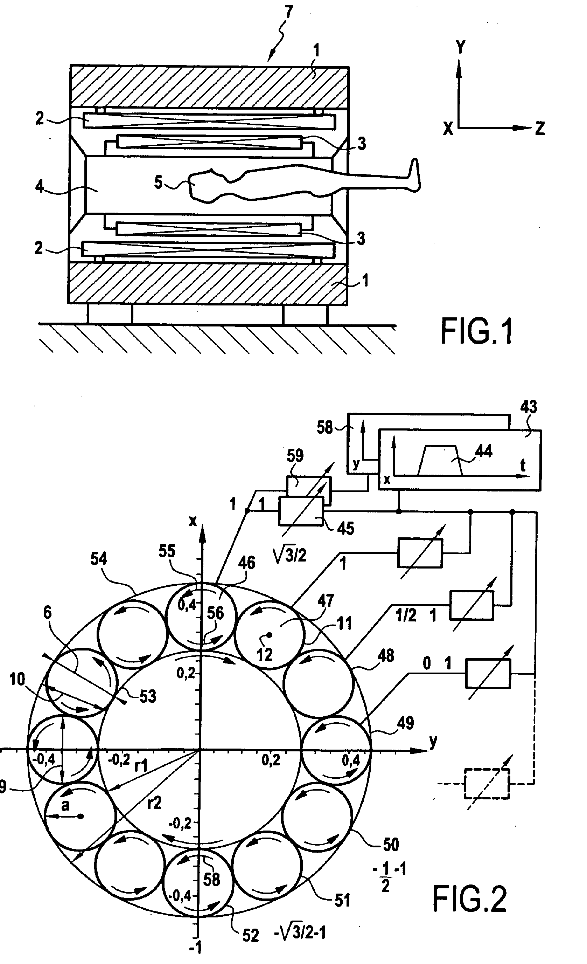

La Figure 1 représente de façon très schématique le principe d'une machine de RMN 7 avec un dispositif 1 de création d'un champ magnétique principal homogène et intense $B_0$ essentiellement parallèle à l'axe Z d'un tunnel 4 dans lequel est installé un patient 5.

Sur la Figure 1, le dispositif 1 de création d'un champ magnétique principal intense $B_0$ peut comprendre des aimants permanents. Toutefois, ce dispositif peut également comprendre de façon privilégiée un aimant supraconducteur placé dans un cryostat destiné à maintenir cet aimant supraconducteur à très basse température. Dans tous les cas, le dispositif 1 de création d'un champ magnétique intense est placé dans une enceinte externe annulaire cylindrique qui ménage un espace annulaire entre la paroi interne de cette enceinte externe et le tunnel 4 dans lequel est placé le patient à examiner 5. L'enceinte externe annulaire cylindrique est généralement fermée par des parois métalliques par exemple en acier inoxydable.

Dans cet espace annulaire situé à l'intérieur du dispositif 1 de création d'un champ magnétique principal intense, sont disposées des bobines de gradient 2 destinées à créer des gradients de champ magnétique à la fois selon la direction de l'axe Z du tunnel 4 et selon les directions X et Y perpendiculaires entre elles et à l'axe Z.

Comme on l'a indiqué précédemment, les bobines de gradient 2 servent à créer un codage dans l'espace où se trouve le patient 5 par l'application de champs magnétiques supplémentaires pulsés.

Les composantes de ces champs magnétiques qui ne sont pas orientés comme le champ orientateur $B_0$ contribuent au deuxième ordre seulement (et donc de manière négligeable pour les valeurs considérées de $B_0$ et des gradients) à la modification du signal de RMN utile. Ainsi, la seule composante de ces champs magnétiques, produite par les bobines de gradient, qui est intéressante et utile est la composante orientée selon le champ $B_0$. Cette composante utile est appelée traditionnellement composante Bz ou $B_z$. La machine est repérée par rapport à un référentiel cartésien, l'axe z étant colinéaire à la direction du champ uniforme $B_0$ et parallèle aux génératrices de la machine tunnel. Selon les différents jeux de bobines de gradient alimentés, la composante Bz utile en un lieu verra son amplitude croître en fonction de l'abscisse x d'un plan contenant ce lieu, parallèle au plan yOz pour les gradients X, en fonction de l'ordonnée y d'un plan contenant ce lieu, parallèle au plan xOz pour les gradients Y, ou en fonction de la cote z d'un plan contenant ce lieu, parallèle au plan xOy pour les gradients Z.

Un dispositif 3 d'antennes d'émission radiofréquence est disposé au voisinage du tunnel 4 où se trouve le patient ou est inséré directement dans ce tunnel. Les bobines ou antennes d'émission radiofréquence sont associées de façon classique à des dispositifs de réception et de traitement des signaux radiofréquence émis en réponse par le corps du patient 5 ou tout autre objet étudié, tel qu'un animal par exemple.

Sur la figure 2, on a montré l'espace annulaire cylindrique 6 comme comportant des bobines solénoïdales circulaires dont le diamètre 9, de valeur 2a, est inscrit dans une épaisseur 10 de cet espace annulaire 6 délimité par des parois cylindriques 53, 54 présentant respectivement des rayons r1 et r2. On peut admettre dans un premier temps que l'épaisseur 10 de l'espace annulaire est égale à l'épaisseur totale de cet espace 6. Dans l'exemple représenté, l'espace annulaire 6 est ainsi occupé par douze tubes matérialisés par des enveloppes en matière plastique 11, ou en un autre matériau isolant électriquement. A l'intérieur des tubes 11, des bobines de production de champs magnétiques de gradient sont engagées, qui peuvent être réalisées comme décrit dans le document WO 2005/029110. De préférence les tubes sont contigus les uns aux autres.

Chaque tube peut être muni d'un jeu de bobines exactement identique à un jeu d'un autre tube. Ce jeu de bobine est avantageusement capable de produire un gradient Z et un gradient dans une direction choisie perpendiculaire à l'axe Z. Par la commande des différentes bobines, on peut destiner les différentes bobines à produire des gradients d'orientation X ou Y.

Dans l'exemple représenté, le nombre de tubes peut être de préférence pair, soit 2n, pour constituer les gradients de type X ou Y, ainsi que les gradients Z. Toutefois une réalisation particulière pourrait comprendre un nombre pair de premiers tubes pour contenir les bobines sinusoïdales destinées à constituer des gradients de type X ou Y et un nombre impair de seconds tubes pour contenir les bobines destinées à constituer les gradients Z.

Ci-après sont exposées quelques notions de base utiles à la compréhension de l'invention.

On notera d'abord qu'un point M quelconque de l'espace peut être repéré par ses coordonnées cartésiennes (x,y,z) ou ses coordonnées sphériques (r, $\vartheta$, $\varphi$) avec :

$$\vec{r} = OM \quad r = |\vec{r}|$$

$$x = r\sin\vartheta\cos\varphi$$

$$y = r\sin\vartheta\sin\varphi$$

$$z \simeq r \cos \vartheta$$

Le champ principal $\vec{B}_0$ est très sensiblement uniforme dans le volume d'intérêt autour de l'origine O et dirigé suivant l'axe Oz :

$$\vec{B}_0 \simeq B_0 \vec{u}_z.$$

Dans une région de l'espace « magnétiquement » vide (c'est-à-dire sans courants électriques ou matériau de susceptibilité magnétique non négligeable), chaque composante $B_x$, $B_y$ et $B_z$ a son laplacien nul. Par exemple, quelles que soient les sources du champ, $\Delta B_z = 0$ et $B_z (\vec{r})$ a un développement unique en harmoniques sphériques de la forme :

$$B_z(r,\theta,\varphi) = Z_0 + \sum_{n=1}^{\infty} r^n \left[ Z_n P_n(\cos\theta) + \sum_{m=1}^{n} \left( X_n^m \cos m\varphi + Y_n^m \sin m\varphi \right) W_n^m P_n^m(\cos\theta) \right]$$

Où $W_n^m$ est un facteur numérique de pondération tel que $\left| W_n^m P_n^m(\cos\theta) \right| \leq 1$ comme $|P_n(\cos\theta)|$.

Ce développement n'est valable que pour $r < r_{max}$, rayon de la plus grande sphère « magnétiquement » vide de centre O. Les coefficients de degré n (on appelle m l'ordre) sont de la forme $\alpha \, r_{max}^{-n}$ où $\alpha$ a la dimension d'un champ et le développement converge d'autant plus rapidement que r est inférieur à $r_{max}$.

La réalisation d'images à partir de signaux de RMN nécessite un codage de l'espace. Ce codage est obtenu au moyen de sources de champ spécifiques dont la composante $b_z$ serait idéalement de la forme $b_z = g_x x$, $b_z = g_y y$ et $b_z = g_z z$ où $g_x$, $g_y$ et $g_z$ sont proportionnels aux courants d'excitation de leurs sources respectives. On les désignera en raccourci par gradient x, gradient y et gradient z respectivement.

En pratique, une telle linéarité ne peut être réalisée que de façon approchée avec des sources qui génèrent des champs b dont les composantes $b_x$ et $b_y$ ne sont pas nulles. Fort heureusement, ceci est sans importance dès lors que $|\vec{b}| \ll B_0$, ce qui est pratiquement toujours le cas. En effet, la fréquence de résonance est proportionnelle à :

$$\left| \vec{B} \right| = \sqrt{(B_0 + b_z)^2 + b_x^2 + b_y^2} = B_0 \sqrt{1 + 2\frac{b_z}{B_0} + \frac{b^2}{B_0^2}}$$

$$\simeq B_0 + b_z + \frac{b_x^2 + b_y^2}{2B_0} + \dots = B_0 + b_z + B_0 \times O\left(\frac{b}{B_0}\right)^2$$

Ainsi, seule la composante $b_z$ intervient au niveau du ppm tant que $\dfrac{b}{B_0} \leq \sim 10^{-3}$.

Appliqué à la réalisation de gradients de champ magnétique, le principe de symétrie permet de démontrer que les propriétés de symétrie de la source de champ considérée conduisent à la nullité de certains des coefficients du développement en harmoniques sphériques susmentionné, quelles que soient les modalités de sa réalisation.

La génération des gradients de champ magnétique pour l'IRM a donné lieu à un nombre considérable de publications et de brevets et fait toujours l'objet d'une recherche intensive. Les modalités d'imagerie les plus modernes, notamment l'imagerie fonctionnelle, nécessitent des gradients les plus linéaires possible, toujours plus puissants et commutables très rapidement alors que le champ principal dans lequel ils doivent fonctionner est de plus en plus grand. Les puissances active et réactive nécessaires deviennent considérables avec les problèmes correspondants de refroidissement, d'isolement et de bruit acoustique.

Les problèmes posés par les courants induits dans les divers conducteurs situés au voisinage des générateurs de gradients deviennent également de plus en plus difficiles à résoudre.

Bien entendu, tous les systèmes connus utilisent les résultats de l'application du principe de symétrie. On peut cependant aller beaucoup plus loin dans l'annulation de certains des coefficients du développement en harmoniques sphériques en combinant plusieurs sources élémentaires alimentées par des courants liés par des relations de proportionnalité appropriées.

Considérons une distribution de courant antisymétrique par rapport au plan xOz et soit antisymétrique (AA), soit symétrique (AS), par rapport au plan xOy.

Une réalisation simple d'une telle distribution est par exemple constituée d'un ensemble de solénoïdes de même axe O'z' parallèle à Oz, à une distance d de celui-ci. Les coordonnées cartésiennes du centre O' de cet ensemble antisymétrique ou symétrique par rapport au plan xOy sont (d,0,0) avec l'une ou l'autre des deux configurations suivantes :

- l'ensemble (AA) comprend un nombre pair de solénoïdes situés de part et d'autre du plan xOy, les solénoïdes géométriquement symétriques étant parcourus par des courants tournant en sens opposés autour de l'axe O'z' (le cas le plus simple comporte donc deux solénoïdes antisymétriques) ;
- l'ensemble (AS) comprend un nombre quelconque de solénoïdes, les solénoïdes géométriquement symétriques par rapport au plan xOy étant parcourus par des courants tournant dans le même sens autour de l'axe O'Z' (le cas le plus simple comporte donc un seul solénoïde admettant xOy comme plan de symétrie).

Mais on peut envisager des configurations plus complexes, des bobinages sur des sections non circulaires et autour de plusieurs axes O'z' par exemple. Les seules conditions à respecter sont les propriétés de symétrie symbolisées par (AA) ou (AS).

Considérons l'un ou l'autre de ces ensembles parcouru par un courant d'intensité I et soit P la puissance dissipée correspondante.

En application directe du principe de symétrie, un ensemble (AA) produit dans la région d'intérêt un champ dont les termes non nuls du développement sont de la forme :

$$Z_{2p+1} \quad \forall p \geq 0$$

$$X_n^m \quad \forall m \geq 1, n = m + 2l + 1 \quad \forall l \geq 0$$

On démontre de la même façon qu'un ensemble (AS) parcouru par un courant d'intensité I produit dans la région d'intérêt un champ dont les termes non nuls du développement sont de la forme :

$$Z_{2p} \quad \forall p \geq 0$$

$$X_n^m \quad \forall m \geq 1, n = m + 2l \quad \forall l \geq 0$$

Les principes suivants peuvent être mis en oeuvre pour la réalisation d'un générateur de gradient Z.

Considérons N sources élémentaires identiques de type (AA) parcourues par le même courant I et régulièrement réparties autour de l'axe Oz. Les coordonnées des traces O'_j de leurs axes sur le plan xOy sont donc :

$$\varphi_j = \varphi_0 + j\frac{2\pi}{N} \quad j \in [0, N-1]$$

où $\varphi_0$ est un azimut origine quelconque.

Le développement en harmoniques sphériques de la composante z du champ total produit est la somme des développements de type (AA) convenablement décalés en azimut φ, soit :

$$B_z(r,\theta,\varphi) = \sum_{p=0}^{\infty} r^{2p+1} N Z_{2p+1} P_{2p+1}(\cos\theta)$$

$$+ \sum_{m=1}^{\infty}\sum_{l=0}^{\infty} r^{m+2l+1} X_{m+2l+1}^{m} \left[\sum_{j=0}^{N-1}\cos m(\varphi - \varphi_j)\right] W_{m+2l+1}^{m} P_{m+2l+1}^{m}(\cos\theta)$$

Les sommes entre crochets se calculent comme suit :

$$\sum_{j=0}^{N-1}\cos m(\varphi - \varphi_j) = \sum_{j=0}^{N-1}\cos\left[m(\varphi - \varphi_0) - j\frac{2m\pi}{N}\right]$$

$$= \left[\sum_{j=0}^{N-1}\cos j\frac{2m\pi}{N}\right]\cos m(\varphi - \varphi_0) + \left[\sum_{j=0}^{N-1}\sin j\frac{2m\pi}{N}\right]\sin m(\varphi - \varphi_0)$$

$$= \left\{\begin{array}{l} 0, m \neq kN \\ N\cos m(\varphi - \varphi_0), m = kN \end{array}\right\} \quad \forall k \geq 1$$

Le développement du champ total se réduit donc à :

$$B_z(r,\theta,\varphi) = N\left[\begin{array}{l} \sum_{p=0}^{\infty} r^{2p+1} Z_{2p+1} P_{2p+1}(\cos\theta) \\ + \sum_{k=1}^{\infty}\sum_{l=0}^{\infty} r^{kN+2l+1} X_{kN+2l+1}^{kN}\cos kN(\varphi - \varphi_0) W_{kN+2l+1}^{kN} P_{kN+2l+1}^{kN}(\cos\theta) \end{array}\right]$$

pour une puissance totale dissipée égale à NP.

Pratiquement, il suffira de choisir N assez grand, par exemple N = 12 ou plus, pour que les contributions des termes en $r^{kN+2l+1} X_{kN+2l+1}^{kN}$ soient tout à fait négligeables et que le développement se réduise à :

$$B_z(r,\theta,\varphi) = N\sum_{p=0}^{\infty} r^{2p+1} Z_{2p+1} P_{2p+1}(\cos\theta)$$

$$= N Z_1 z + N\sum_{p=1}^{\infty} r^{2p+1} Z_{2p+1} P_{2p+1}(\cos\theta)$$

La linéarité du générateur du gradient z ainsi obtenu sera d'autant meilleure que l'on annulera plus de termes de degré 2p+1, p=1,2... du développement. Cette annulation ne dépend plus de considérations de symétrie mais de la distribution effective des courants dans la source élémentaire.

Dans une réalisation simple de la source élémentaire à base de solénoïdes coaxiaux, on peut, avec le minimum de deux solénoïdes géométriquement symétriques par rapport au plan xOy et parcourus par des courants opposés, choisir leurs dimensions et leurs positions pour annuler $Z_3$, le premier terme gouvernant les défauts de linéarité étant alors $Z_5$. Avec quatre solénoïdes de dimensions et positions convenablement choisies, on peut annuler $Z_3$ et $Z_5$, le premier terme gouvernant les défauts de linéarité devenant $Z_7$, etc.

Dans une recherche d'optimisation d'un tel générateur, on peut introduire d'autres considérations comme la minimisation de la puissance continue nécessaire pour obtenir un gradient permanent donné ou la minimisation de l'inductance pour permettre des temps de montée plus courts avec une tension maximum donnée ou encore une adaptation aux alimentations ou amplificateurs disponibles. Il est important de noter que ce principe de réalisation permet très facilement de recourir à plusieurs alimentations ou amplificateurs, réduisant ainsi leurs puissances unitaires.

La réalisation, suivant les mêmes principes, d'un générateur de gradient x (pour un générateur de gradient y le raisonnement est le même avec une rotation de $\dfrac{\pi}{2}$ autour de Oz) est également possible et se révèle tout aussi efficace pour obtenir la linéarité recherchée.

On doit utiliser un nombre pair N = 2n de sources élémentaires de type (AS) régulièrement réparties autour de l'axe Oz, le plan xOz étant un plan de symétrie de l'ensemble. Ce dernier élément de symétrie impose que l'azimut origine $\varphi_0$ soit O ou $\dfrac{\pi}{2n}$.

Les coordonnées des traces $O'_j$ de leurs axes sur le plan xOy sont donc soit

$$\varphi_j = j\frac{\pi}{n} \text{ , soit } \varphi_j = \frac{\pi}{2n} + j\frac{\pi}{n} \quad j \in [0, 2n-1].$$

On démontre alors que si les sources élémentaires sont alimentées par des courants d intensité $I_j = I\cos\varphi_j$, le développement en harmoniques sphériques de la composante z du champ total produit se réduit à :

$$B_z(r,\theta,\varphi) = n \left[ \begin{array}{l} \displaystyle\sum_{p=0}^{\infty} r^{2p+1} X_{2p+1}^1 \cos\varphi W_{2p+1}^1 P_{2p+1}^1(\cos\theta) \\[2mm] + \begin{bmatrix} 1 \\ (-1)^k \end{bmatrix} \displaystyle\sum_{k=1}^{\infty}\sum_{l=0}^{\infty} r^{2kn-1+2l} X_{2kn-1+2l}^{2kn-1} \cos(2kn-1)\varphi W_{2kn-1+2l}^{2kn-1} P_{2kn-1+2l}^{2kn-1}(\cos\theta) \\[2mm] + \begin{bmatrix} 1 \\ (-1)^k \end{bmatrix} \displaystyle\sum_{k=1}^{\infty}\sum_{l=0}^{\infty} r^{2kn+1+2l} X_{2kn+1+2l}^{2kn+1} \cos(2kn+1)\varphi W_{2kn+1+2l}^{2kn+1} P_{2kn+1+2l}^{2kn+1}(\cos\theta) \end{array} \right]$$

pour une puissance totale dissipée égale à nP.

Le calcul est similaire à celui présenté précédemment avec les sommes suivantes à calculer :

$$\sum_{j=0}^{2n-1} \cos\varphi_j \cos m\varphi_j = \left\{ \begin{array}{l} 0, m \neq 2kn \pm 1 \\ \begin{bmatrix} 1 \\ (-1)^k \end{bmatrix}, m = 2kn \pm 1 \end{array} \right\}$$

$$\sum_{j=0}^{2n-1} \cos\varphi_j \sin m\varphi_j = 0 \quad \forall m$$

le facteur $(-1)^k$ correspond au cas où l'azimut origine est $\dfrac{\pi}{2n}$. Comme pour le gradient z, il suffit de choisir N = 2n (n étant un entier) assez grand pour que les contributions des termes en $r^{2kn\pm1+2l}$ $X^{2kn\pm1}_{2kn\pm1+2l}$ soient tout à fait négligeables et que le développement se réduise à :

$$B_z(r,\theta,\varphi) \simeq n\sum_{p=0}^{\infty} r^{2p+1} X^1_{2p+1} \cos\varphi W^1_{2p+1} P^1_{2p+1}(\cos\theta)$$

$$= nX^1_1 x + n\sum_{p=1}^{\infty} r^{2p+1} X^1_{2p+1} \cos\varphi W^1_{2p+1} P^1_{2p+1}(\cos\theta)$$

La linéarité du générateur de gradient x ainsi obtenu sera d'autant meilleure que l'on annulera plus de termes de degré 2p+1, p = 1,2... du développement. Cette annulation ne dépend plus de considérations de symétrie mais de la distribution effective des courants dans la source élémentaire.

Dans une réalisation simple de la source élémentaire à base de solénoïdes coaxiaux avec le minimum d'un seul solénoïde, on ne peut annuler aucun des coefficients $X^1_{2p+1}$ $\forall p\geq1$. Il faut au moins deux solénoïdes symétriques par rapport au plan xOy de dimensions et positions convenablement choisies pour annuler $X^1_3$, le premier terme gouvernant les défauts de linéarité étant alors $X^1_5$. Avec trois solénoïdes de dimensions et positions convenablement choisies, on peut annuler $X^1_3$ et $X^1_5$, le premier terme gouvernant les défauts de linéarité devenant $X^1_7$, etc.

Comme pour le générateur de gradient z, l'optimisation du système fera intervenir des considérations de puissance continue dissipée et d'inductance. Mais alors que pour le premier on pouvait avoir une seule alimentation avec toutes les sources élémentaires en série puisque l'intensité du courant était la même pour toutes, il faudra ici au moins autant d'alimentations que de valeurs de courants différentes (en valeur absolue).

Un autre aspect très important d'un tel dispositif est que ce sont les mêmes sources élémentaires qui peuvent servir à produire le gradient x et le gradient y, sans que l'on ait à mettre en place deux ensembles physiquement distincts comme dans les systèmes connus, notamment ceux décrits dans le document US 5 530 355.

Chaque source élémentaire sera ainsi alimentée par la somme algébrique des courants nécessaires à la production simultanée des deux valeurs de gradient souhaitées, suivant les formules explicitées supra. On notera toutefois que si les intensités et gradients s'ajoutent algébriquement, il n'en est pas de même des puissances dissipées qu'il importe de calculer pour chaque source élémentaire en fonction des séquences de gradients à produire.

Comme les valeurs des gradients x et y doivent être commandées séparément, on devra disposer in fine d'au moins n alimentations distinctes, soit une alimentation pour chaque paire de sources élémentaires antisymétriques par rapport à l'axe Oz.

Enfin, pour meilleure utilisation de l'espace limité disponible pour les générateurs de gradient, on peut adopter le même nombre de sources élémentaires pour les gradients x et y d'une part et pour le gradient z d'autre part, en réalisant une source élémentaire composite (AS) et (AA). Dans la réalisation simple d'une telle source élémentaire à base de solénoïdes coaxiaux, on peut par exemple combiner deux solénoïdes, symétriques par rapport au plan xOy, de dimensions et positions convenablement choisies pour annuler $X^1_3$ et quatre solénoïdes, antisymétriques deux à deux par rapport au plan xOy, de part et d'autre de chacun des deux solénoïdes précédents, avec des dimensions et positions convenablement choisies pour annuler $Z_3$ et $Z_5$.

Pour l'alimentation des bobines de gradient , la figure 2 montre que, pour un gradient X, un circuit électronique 43 produit une impulsion temporelle 44 ayant la forme (temps de montée, temps de descente) et la durée requise par une séquence d imagerie à mettre en oeuvre avec la machine de RMN. Le signal 44 représentatif de l'impulsion est introduit dans un amplificateur 45 à gain variable et commandé.

La commande appliquée sur l'amplificateur 45, produite par un système informatique qui gère les séquences, provoque l'application d'un courant nominal multiplié par un coefficient qui vaut ici 1 pour les bobines situées dans un tube 46 situé dans le plan xOz.

Un tube 47 contigu au tube 46 dont l'axe, ici 12, est situé dans un plan passant par l'axe z et incliné de π/6 par rapport au plan xOz est alimenté par un courant multiplié par un coefficient valant √2. Pour un tube 48 contigu au tube 47 et encore décalé de ce dernier de π/6, le courant est multiplié par 1/2. Pour un tube 49 contigu au tube 48, et situé dans un plan yOz, le coefficient vaut 0. Pour un tube 50 symétrique du tube 48, le coefficient vaut -1/2, pour un tube 51 symétrique du tube 47, il vaut - √3/2, et pour un tube 52 symétrique du tube 46 par rapport à l'axe Z, le coefficient vaut -1. Pour les tubes situées à gauche de la figure et symétriques des tubes 46 à 52 par rapport au plan xOz, les valeurs de coefficient sont les mêmes (négatives en dessous de l'axe Y, positives au dessus de l'axe Y).

Le courant dans une bobine est ainsi proportionnel au cosinus de l'angle de repérage du tube qui la contient sur le pourtour de l'espace circulaire. Cette répartition des courants selon une variante peut également être décalée de 15°.

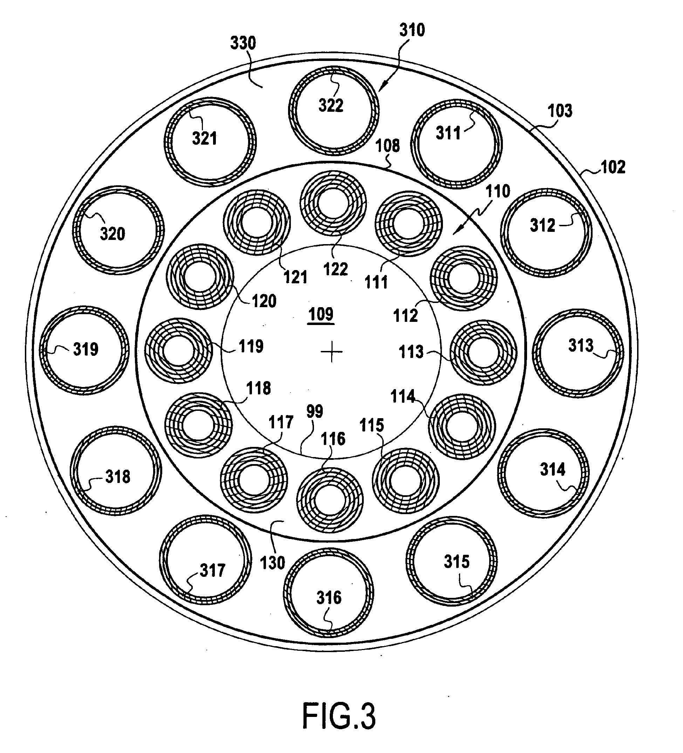

La figure 3 montre un example selon lequel, entre la paroi interne, par exemple en acier inoxydable, de l'enceinte cryogénique extérieure 102 incorporant le dispositif 101 de création de champ magnétique principal $B_0$ et la paroi 99 délimitant un espace intérieur utile 109 en forme de tunnel d'axe Z destiné à recevoir un patient, on trouve non seulement un espace annulaire cylindrique 130 destiné à recevoir un ensemble 110 de bobines de gradient solénoïdales 111 à 122 contenues dans des tubes d'axe parallèle à l'axe z, et pouvant être réalisées de la manière décrite précédemment, mais également un espace annulaire cylindrique supplémentaire 330 dans lequel est disposé un deuxième ensemble 310 de bobines de gradient solénoïdales circulaires qui sont incorporées dans des tubes disposés de façon parallèle à l'axe z.

Le sens de circulation des courants pulsés dans les bobines de gradient solénoïdales circulaires 311 à 322 du deuxième ensemble 310 est inversé par rapport au sens de circulation des courants pulsés dans les bobines de gradient solénoïdales circulaires 111 à 122 du premier ensemble 110 de manière à créer des gradients de champ en sens inverse qui réduisent le potentiel vecteur et les courants de Foucault induits dans l'enceinte cryogénique extérieure 102.

Dans l'exemple de la figure 3, on a un même nombre de tubes équipés de bobines de gradient solénoïdales pour le premier ensemble 110 et pour le deuxième ensemble 310. Ce nombre est à titre d'exemple égal à 12 mais il peut être avantageusement compris entre 8 et 18. Il n'est par ailleurs pas obligatoire que les ensembles 150 et 310 comportent le même nombre de tubes.

Sur la figure 3, on voit que les bobines de gradient 111 à 122 du premier ensemble 110 sont régulièrement réparties dans l'espace annulaire 130 et pratiquement contiguës les unes aux autres. Les bobines de gradient 311 à 322 du deuxième ensemble 310 sont également régulièrement réparties dans l'espace annulaire 330 avec des espaces libres entre deux bobines voisines. Les bobines 311 à 322 pourraient aussi être disposées de façon à être contiguës les unes aux autres et à l'inverse, les bobines 111 à 122 pourraient également ne pas être disposées de façon contiguë les unes à côté des autres. Toutefois, par mesure d'efficacité, il est préférable que les bobines de gradient 111 à 122 du premier ensemble 110 soient contiguës dès lors qu'elles créent le champ utile et sont disposées dans un espace cylindrique annulaire de plus faible diamètre, tandis que les bobines de gradient 311 à 322 du deuxième ensemble 310, qui ne jouent qu'un rôle de compensation et sont situées dans un espace cylindrique annulaire 330 de plus grand diamètre, peuvent être disposées de façon non contiguë pour réduire le coût.

Le deuxième ensemble 310 de bobines de gradient 311 à 322 peut être réalisé selon les mêmes principes que le premier ensemble 110 de bobines de gradient 111 à 122. En particulier, les bobines de gradient 111 à 122 peuvent produire des gradients selon les axes x, y et z si elles sont en nombre pair, ou ces bobines peuvent ne produire des gradients que selon les axes x et y, les gradients selon l'axe z étant produits par des bobines conventionnelles disposées au niveau du cylindre 103 au voisinage de la paroi 102 du cryostat.

Tout en conservant tous les avantages de la technologie des bobines de gradient solénoïdales circulaires disposées dans des tubes et pouvant être facilement refroidies, la présence du deuxième ensemble 310 de bobines de gradient 311 à 322 permet de réduire de façon particulièrement efficace les courants induits qui sinon apparaissent dans tous les éléments conducteurs du système, notamment les enveloppes du cryostat de l'aimant principal et ses écrans thermiques et sont à l'origine d'une dissipation de chaleur augmentant la consommation de fluide cryogénique dans le cryostat. L'invention permet également de réduire le bruit acoustique créé par les courants induits et de limiter la distorsion des gradients que l'on souhaite produire.

Comme on l'a déjà indiqué, l'invention peut s'appliquer à des machines de RMN dans lesquelles les bobines de gradients 111 à 122 sont telles qu'une bobine solénoïdale circulaire dont le diamètre est inscrit dans l'espace annulaire cylindrique 130 et qui produit un gradient de champ z dans une première direction z est coaxiale avec une autre bobine solénoïdale inscrite dans un même tube de cet espace annulaire cylindrique 130 et produisant un gradient de champ X dans une direction inclinée x par rapport à la direction z.

L'invention peut toutefois s'appliquer de la même manière à des machines de RMN dans lesquelles seules les bobines de gradient 111 à 122 de type solénoïdal produisant des gradients de champ X, Y dans des directions perpendiculaires à la direction z sont disposées dans des tubes dans l'épaisseur de l'espace annulaire cylindrique 130, tandis que pour la production du gradient de champ z on recourt à une solution plus classique dans laquelle des bobines annulaires de production d'un gradient de champ magnétique orienté selon une génératrice de la machine sont disposées sur une paroi externe 108 de cet espace annulaire 130 et non à l'intérieur de cet espace. Les solutions classiques présentent en effet moins d'inconvénients pour la création d'un gradient de champ Z que pour la création de gradients de champ X, Y.

Dans ce cas, en ce qui concerne les bobines de compensation, on peut avoir un dispositif dans lequel seules les bobines 311 à 322 de type solénoïdal produisant des gradients de champ X, Y dans des directions perpendiculaires à la direction z sont disposées dans des tubes dans l'épaisseur de l'espace annulaire cylindrique supplémentaire 330, tandis que pour la production du gradient de champ Z on recourt à une solution plus classique dans laquelle des bobines annulaires de production d'un gradient de champ magnétique orienté selon une génératrice de la machine sont disposées sur une paroi externe 103 de cet espace annulaire cylindrique supplémentaire 330 et non à l'intérieur de cet espace.

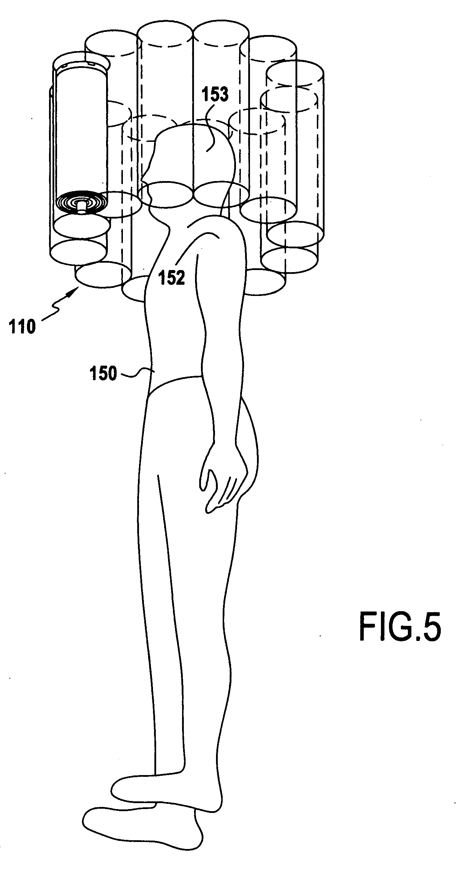

L'efficacité des générateurs de gradient en régime permanent $\frac{G}{\sqrt{P}}$ (où G est le gradient de champ produit pour une puissance dissipée p) est d'autant meilleure que les courants sources sont proches du volume d'intérêt. L'inductance est également réduite si les dimensions du générateur sont plus faibles. C'est pour cette raison que l'on réalise des systèmes spécifiques pour l'imagerie du cerveau appelés « gradients tête » de dimensions bien inférieures à celle des gradients dits « corps entier ». La figure 5 montre schématiquement un exemple avec un patient 150 dont seule la tête 153 est insérée à l'intérieur du volume d'intérêt sur lequel agit l'ensemble 110 des bobines de gradient. Certaines contradictions entre les contraintes géométriques résultant des équations de Maxwell d'une part et de la morphologie du corps humain d'autre part pourraient être levées si de la place était libérée pour le passage des épaules 151, 152 du sujet à examiner. On supposera que celui-ci est installé de façon telle qu'il est allongé suivant l'axe Oz et que l' « axe » de ses épaules est dans le plan xOz et parallèle à Ox.

Afin de ménager un passage libre pour les épaules 151, 152, on considère une configuration de générateurs de gradients à N=2n sources élémentaires d'azimut origine $\varphi_0 = 0$ dans laquelle on supprime les deux sources élémentaires correspondant à $\varphi_j = 0$ et $\varphi_j = \pi$. Il est alors encore possible de trouver des combinaisons de courants d'alimentation des sources élémentaires qui conduisent à la meilleure linéarité possible, avec une réduction de l'efficacité qui reste acceptable.

Dans le cas du générateur de gradient z constitué par des bobines solénoïdales circulaires placées dans l'espace annulaire 130, on part simplement d'une configuration à N = 2n sources élémentaires avec $\varphi_0 = 0$ et on supprime une source sur deux.

Si le nombre entier n est suffisamment grand, la linéarité sera toujours gouvernée par la structure de la source élémentaire. L'efficacité $\frac{G}{\sqrt{P}}$ est seulement divisée par $\sqrt{2}$.

Ce faisant, on a non seulement ménagé un passage pour les épaules 151, 152 du patient mais aussi suivant d'autres directions, celles qui correspondent aux autres sources supprimées, ce qui peut présenter un intérêt en termes d'accessibilité ou de logement d'accessoires.

En ce qui concerne le générateur de gradient x et y constitué par des bobines solénoïdales circulaires placées dans l'espace annulaire 130, on doit distinguer deux cas suivant que n est pair ou impair.

n pair

Si n = 2υ, la solution est la même que pour le gradient z. Si υ est suffisamment grand, la linéarité sera toujours gouvernée par la structure de la source élémentaire et l'efficacité $\frac{G}{\sqrt{P}}$ est simplement divisée par $\sqrt{2}$.

n impair

le cas n = 2υ+1 implique de supprimer effectivement que les deux sources élémentaires correspondant au passage des épaules et de nouvelles relations doivent être établies entre les courants des sources restantes. On remarquera cependant que pour le gradient y, rien n'est changé par rapport au cas sans suppression de source puisque les deux sources élémentaires supprimées n'étaient alors pas alimentées. La linéarité et l'efficacité de ce gradient y sont donc conservées.

Pour le gradient x on doit prendre en compte les aspects suivants : les coordonnées des traces O'$_j$ des axes des sources élémentaires sur le plan xOy sont maintenant $\varphi_j = j \dfrac{\pi}{2v+1}$ $j \in [1,2v] \cup [2v+2, 4v+1]$ et la meilleure linéarité possible est obtenue avec des courants d'intensités :

$$I_j = I\left[\cos\varphi_j - (-1)^j\right]$$

Les calculs se déroulent en remplaçant $\cos\varphi_j$ par $\cos\varphi_j-(-1)^j$ dans les sommes à calculer et en remarquant que la sommation sur j peut être étendue, de 0 à 2n-1=4$\upsilon$+1 puisque j=0 et j=2$\upsilon$+1 correspondant aux sources élémentaires supprimées donnent $\cos\varphi_j-(-1)^j=0$.

On trouve alors :

$$B_z(r,\theta,\varphi) = n \left[ \begin{array}{l} \sum_{p=0}^{\infty} r^{2p+1} X_{2p+1}^1 \cos\varphi\, W_{2p+1}^1 P_{2p+1}^1(\cos\theta) \\ -2\sum_{k=1}^{\infty}\sum_{l=0}^{\infty} r^{(2k-1)n+2l} X_{(2k-1)n+2l}^{(2k-1)n} \cos(2k-1)n\varphi\, W_{(2k-1)n+2l}^{(2k-1)n} P_{(2k-1)n+2l}^{(2k-1)n}(\cos\theta) \\ +\sum_{k=1}^{\infty}\sum_{l=0}^{\infty} r^{2kn-1+2l} X_{2kn-1+2l}^{2kn-1} \cos(2kn-1)\varphi\, W_{2kn-1+2l}^{2kn-1} P_{2kn-1+2l}^{2kn-1}(\cos\theta) \\ +\sum_{k=1}^{\infty}\sum_{l=0}^{\infty} r^{2kn+1+2l} X_{2kn+1+2l}^{2kn+1} \cos(2kn+1)\varphi\, W_{2kn+1+2l}^{2kn+1} P_{2kn+1+2l}^{2kn+1}(\cos\theta) \end{array} \right]$$

avec une puissance dissipée égale à 3nP.

La linéarité est donc moins bonne que celle du gradient y avec de nouveaux termes non nuls en $X_{(2k-1)n+2l}^{(2k-1)n}$, notamment celui de degré le plus bas $X_n^n$, mais il suffira de choisir n assez grand pour garantir la qualité recherchée.

L'efficacité en régime permanent est simplement divisée par $\sqrt{3}$.

Pour aménager l'accessibilité au niveau des épaules 151, 152 d'un patient, on a donc le choix entre deux configurations possibles.

On peut dimensionner les sources élémentaires comme si l'on devait en disposer un nombre multiple de 4, N=4$\upsilon$, et n'en installer effectivement qu'une sur deux , soit 2$\upsilon$. Cette solution est valable pour les gradients dans les trois directions et réduit pour chacun l'efficacité d'un facteur $\sqrt{2}$ par rapport à la situation où l'on aurait installé les N=4$\upsilon$ sources. Elle permet également d'utiliser des sources élémentaires combinées pour les axes x y et z.

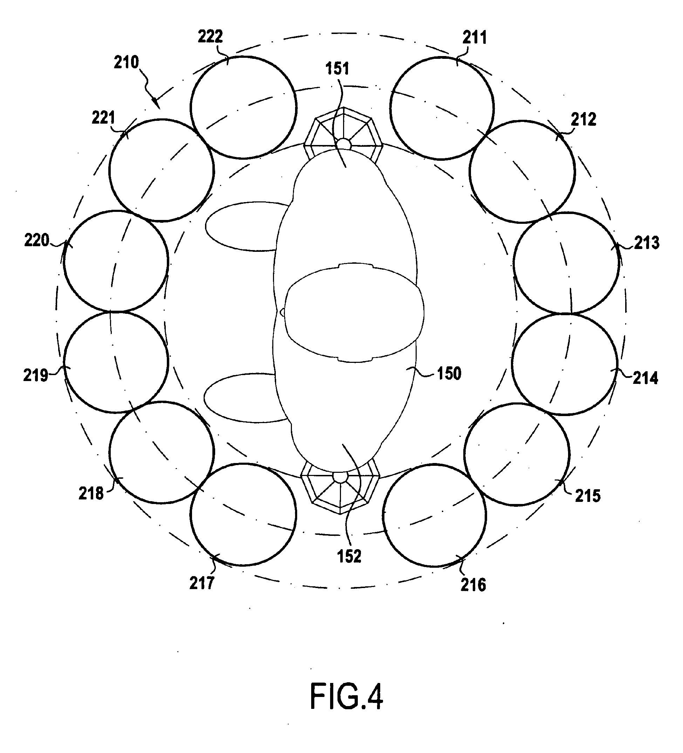

On peut également dimensionner les sources élémentaires comme si l'on devait en disposer un nombre N=4$\upsilon$+2 et n'en installer effectivement que 4$\upsilon$ (références 211 à 222 de la figure 4) en supprimant les deux sources élémentaires correspondant au passage des épaules 151, 152 dans le plan xOz. Le gradient y est alors identique à celui que l'on aurait obtenu avec toutes les sources alors que le gradient x a son efficacité réduite d'un facteur $\sqrt{3}$. Il n'y a pas de solution de ce type pour le gradient z qui doit, dans ces conditions, être installé dans un espace extérieur à celui occupé par l'ensemble 210 des sources précédents et ne nécessite donc plus d'aménagement particulier pour le passage des épaules.

Les considérations qui précèdent s'appliquent naturellement au premier ensemble 210 de bobines de gradient solénoïdales 211 à 222, seul représenté sur la figure 4. Sur la figure 4 on n'a pas représenté à nouveau l'ensemble 310 de bobines de gradient solénoïdales 311 à 322 qui assurent une simple compensation et sont inchangées.

Les mesures proposées ci-dessus pour faciliter le passage des épaules 151, 152 d'un patient 150 sont toutefois particulièrement avantageuses en combinaison avec un ensemble 310 de bobines de gradient de compensation, car elles minimisent les inconvénients de l'espace annulaire cylindrique 330 utilisé par cet ensemble 310 de bobines de gradient de compensation.

**Revendications**

1.  Machine de résonance magnétique nucléaire, comprenant des moyens (101) de création d'un champ magnétique principal intense $B_0$ dans un espace intérieur utile (109) en forme de tunnel d'axe Z, des moyens d'excitation radiofréquence et de traitement des signaux radiofréquence émis en réponse par un corps (150) ou objet disposé dans ledit espace intérieur utile (109), et un premier ensemble (110, 210) de bobines de gradient solénoïdales pour superposer au champ magnétique intense $B_0$ des composants d'un champ magnétique supplémentaire, lesdites bobines de gradient (111-122 ; 211-222) étant incorporées dans des tubes disposés de façon parallèle à l'axe Z dans un espace annulaire cylindrique (130) situé entre une enceinte cryogénique extérieure (102) contenant lesdits moyens (101) de création d'un champ magnétique intense $B_0$ et ledit espace intérieur utile (109), le diamètre des bobines de gradient (111-122 ; 211-222) étant inscrit dans une épaisseur dudit espace annulaire cylindrique (130), les bobines de gradient solénoïdales (111-122 ; 211-222) du premier ensemble (110) étant adaptées pour produire à la fois un premier gradient de champ X dans une première direction x radiale de la machine perpendiculaire à l'axe Z, et un deuxième gradient de champ Y dans une deuxième direction y radiale de la machine également perpendiculaire à l'axe Z, la première direction x étant perpendiculaire à la deuxième direction y, et la machine comportant des amplificateurs (45, 59) pour alimenter simultanément ces bobines solénoïdales par des sommes algébriques de courants correspondant aux deux gradients, et l'espace annulaire cylindrique (130) comportant sur une paroi externe (108) de celui-ci des bobines annulaires de production d'un gradient de champ magnétique Z orienté parallèlement à la direction du champ magnétique principal $B_0$ tandis que les bobines solénoïdales (111-122 ; 211-222) du premier ensemble sont toutes disposées dans l'épaisseur de l'espace annulaire cylindrique (130), **caracterisée en ce que** les bobines de gradients solénoïdales (211 à 222) incorporées dans des tubes constituent des sources élémentaires de gradients de champ X et Y dans lesdites directions x et y, qui sont dimensionnées comme faisant partie d'un ensemble de N sources élémentaires contiguës réparties selon le pourtour de l'espace annulaire cylindrique, où $N = 4\upsilon + 2$, $\upsilon$ étant un entier supérieur ou égal à 1, mais où deux sources élémentaires diamétralement opposées correspondant à un plan axial xOz sont omises pour ne conserver que $4\upsilon$ sources élémentaires contiguës réparties en deux sous-ensembles (211-216, 217-222) séparés par des espaces libres, chaque tube étant muni d'une source élémentaire.

2.  Machine selon la revendication 1, **caractérisée en ce qu'**elle comprend en outre entre ladite enceinte cryogénique extérieure (102) et ledit espace annulaire cylindrique (130) un espace annulaire cylindrique supplémentaire (330) dans lequel est disposé un deuxième ensemble (310) de bobines de gradient solénoïdales qui sont incorporées dans des tubes disposés de façon parallèle à l'axe Z, le deuxième ensemble arrangé de telle sorte que le sens de circulation des courants pulsés dans les bobines de gradient solénoïdales (311 à 322) dudit deuxième ensemble (310) soit inversé par rapport au sens de circulation des courants pulsés dans les bobines de gradient solénoïdales (111 à 122) dudit premier ensemble (110) de manière à créer des gradients de champ en sens inverse qui réduisent le potentiel vecteur et les courants de Foucault induits dans l'enceinte cryogénique extérieure (102).

3.  Machine selon la revendication 2, **caractérisée en ce que** le nombre des bobines de gradient solénoïdales (311 à 322) incorporées dans l'ensemble des tubes du deuxième ensemble (310) est identique au nombre de bobines de gradient solénoïdales (111 à 122) incorporées dans l'ensemble des tubes du premier ensemble (110).

4.  Machine selon la revendication 2, **caractérisée en ce que** le nombre de bobines de gradient solénoïdales (311 à 322) incorporées dans l'ensemble des tubes du deuxième ensemble (310) est différent du nombre de bobines de gradient solénoïdales (111 à 122) incorporées dans l'ensemble des tubes du premier ensemble (110).

5.  Machine selon l'une quelconque des revendications 2 à 4, **caractérisée en ce que** l'espace annulaire cylindrique supplémentaire (330) comporte sur une paroi externe (103) de celui-ci des bobines annulaires de compensation arrangées à produire un gradient de champ magnétique Z orienté selon la direction du champ magnétique principal $B_0$, tandis que les bobines solénoïdales (311-322) dudit deuxième ensemble (310) produisant des gradients de champ X, Y dans lesdites directions x et y sont toutes disposées dans l'épaisseur de l'espace annulaire cylindrique supplémentaire (330).

6.  Machine selon l'une quelconque des revendications 1 à 5, **caractérisée en ce que** les bobines solénoïdales (111-122 ; 211-222) du premier ensemble (110 ; 210) sont réparties selon le pourtour de l'espace annulaire (130) en 2n arrangements de bobines solénoïdales coaxiales où n est un entier supérieur ou égal à 3, et le cas échéant les bobines solénoïdales (311-322) du deuxième ensemble (310) sont réparties selon le pourtour de l'espace annulaire cylindrique supplémentaire (330) en 2n arrangements de bobines solénoïdales coaxiales où n est un entier supérieur ou égal à 3.

7. Machine selon l'une quelconque des revendications 1 à 5, **caractérisée en ce que** les bobines solénoïdales (111-122 : 211-222) du premier ensemble (110 ; 210) sont réparties selon le pourtour de l'espace annulaire (130) en 2n arrangements de bobines solénoïdales coaxiales où n est un entier supérieur ou égal à 3, et le cas échéant, les bobines solénoïdales (311-322) du deuxième ensemble (310) sont réparties selon le pourtour de l'espace annulaire cylindrique supplémentaire (330) en 2n arrangements de bobines solénoïdales coaxiales, lesdites amplificateurs arrangés pour alimenter plusieurs bobines simultanément par des combinaisons de courants pour produire un gradient X et Y, n étant un entier supérieur ou égal à 3.

8. Machine selon la revendication 7, arrangée de telle sorte qu'une composante d'un courant qui passe dans une bobine pour produire un gradient soit proportionnelle à un courant nominal multiplié par un cosinus d'un angle de repérage de la bobine sur le pourtour de l'espace annulaire.

9. Machine selon l'une quelconque des revendications 1 à 5, **caractérisée en ce que** l'espace annulaire (130) comporte plusieurs tubes contigus répartis sur le pourtour pour recevoir les bobines solénoïdales, le rayon a d'un tube étant donné par $a = r1(\sin\pi/N)/(1-\sin n\pi/N) = r2(\sin\pi/N)/(1+\sin\pi/N)$, formule dans laquelle N représente le nombre de tubes et r1 et r2 les rayons intérieur et extérieur respectivement de l'espace annulaire (130).

10. Machine selon l'une quelconque des revendications 1 à 9, arrangée de telle sorte que des bobines solénoïdales soient alimentées par des alimentations électriques individualisées.

11. Machine selon l'une quelconque des revendications 1 à 10, **caractérisée en ce que** les bobines solénoïdales sont formées de spires, de préférence à profil rectangulaire, hélicoïdales allongées le long de manchons circulaires conducteurs, plusieurs manchons d'une même bobine étant concentriques et engagés les uns dans les autres.

12. Machine selon la revendication 11, **caractérisée en ce qu'**un espace annulaire entre deux manchons est parcouru par un fluide de refroidissement.

## Claims

1. A nuclear magnetic resonance machine comprising means (101) for creating an intense main magnetic field $B_0$ in a usable interior space (109) in the form of a tunnel with axis Z, means for radio-frequency excitation and for processing radio-frequency signals emitted in response by a body (150) or object placed in said usable interior space (109), and a first set (110, 210) of solenoidal gradient coils for superimposing on the intense magnetic field $B_0$ components of an additional magnetic field, said gradient coils (111-122; 211-222) being incorporated into tubes disposed parallel to the axis Z in an annular cylindrical space (130) situated between an exterior cryogenic enclosure (102) containing said means (101) for creating an intense magnetic field $B_0$ and said usable interior space (109), the diameter of the gradient coils (111-122; 211-222) being inscribed in a thickness of said annular cylindrical space (130), the solenoidal gradient coils (111-122; 211-222) of the first set (110) being adapted to produce a first or X field gradient in a first radial direction (x) of the machine perpendicular to the axis Z and a second or Y field gradient in a second radial direction (y) of the machine also perpendicular to the axis Z, the first direction (x) being perpendicular to the second direction (y), and the machine including amplifiers (45, 59) for simultaneously energizing said solenoidal coils with algebraic sums of currents corresponding to the two gradients, and the annular cylindrical space (130) including on an external wall (108) thereof annular coils for producing a Z magnetic field gradient oriented parallel to the direction of the main magnetic field $B_0$ whereas the solenoidal coils (111-122; 211-222) of the first set are all disposed within the thickness of the annular cylindrical space (130), **characterized in that** the solenoidal gradient coils (211 to 222) incorporated in tubes constitute individual sources of X and Y field gradients in said x and y directions, which are sized as forming part of a set of N contiguous individual sources distributed at the perimeter of the annular cylindrical space, where $N = 4\upsilon + 2$, $\upsilon$ being an integer greater than or equal to 1, but where two diametrically opposite individual sources corresponding to an axial plane xOz are omitted to retain only $4\upsilon$ contiguous individual sources distributed in two subsets (211-216, 217-222) separated by gaps, each tube being provided with one individual source.

2. A machine according to claim 1, **characterized in that** it further comprises between said exterior cryogenic enclosure (102) and said annular cylindrical space (130) an additional annular cylindrical space (330) in which is disposed a second set (310) of solenoidal gradient coils that are incorporated in tubes disposed parallel to the axis Z, the second set being arranged such that the direction of the pulsed currents in the solenoidal gradient coils (311 to 322) of said second set (310) is reversed relative to the direction of the pulsed currents in the solenoidal gradient coils (111 to 122) of said first set (110) to create reverse direction field gradients that reduce the vector potential and the eddy currents induced in the exterior cryogenic enclosure (102).

3. A machine according to claim 2, **characterized in that** the number of solenoidal gradient coils (311 to 322) incorporated in all the tubes of the second set (310) is identical to the number of solenoidal gradient coils (111 to 122) incorporated in all the tubes of the first set (110).

4. A machine according to claim 2, **characterized in that** the number of solenoidal gradient coils (311 to 322) incorporated in all the tubes of the second set (310) is different from the number of solenoidal gradient coils (111 to 122) incorporated in all the tubes of the first set (110).

5. A machine according to any one of claims 2 to 4, **characterized in that** the additional annular cylindrical space (330) includes on an external wall (103) thereof annular compensating coils arranged for producing a Z magnetic field gradient oriented in the direction of the main magnetic field $B_0$, whereas the solenoidal coils (311-322) of the second set (310) producing X, Y field gradients in said directions x and y are all disposed within the thickness of the additional annular cylindrical space (33).

6. A machine according to any one of claims 1 to 5, **characterized in that** the solenoidal coils (111-122; 211-222) of the first set (110; 210) are distributed at the perimeter of the annular space (130) in 2n arrangements of coaxial solenoidal coils where n is an integer greater than or equal to 3, and if that is the case the solenoidal coils (311-322) of the second set (310) are distributed at the perimeter of the additional annular cylindrical space (330) in 2n arrangements of coaxial solenoidal coils where n is an integer greater than or equal to 3.

7. A machine according to any one of claims 1 to 5, **characterized in that** the solenoidal coils (111-122; 211-222) of the first set (110; 210) are distributed at the perimeter of the annular space (130) in 2n arrangements of coaxial solenoidal coils, where n is an integer greater than or equal to 3 and if that is the case the solenoidal coils (311-322) of the second set (310) are distributed at the perimeter of the additional annular cylindrical space (330) in 2n arrangements of coaxial solenoidal coils, said amplifiers being arranged to simultaneously feed several coils by combinations of currents to produce an X and Y gradient, where n is an integer greater than or equal to 3.

8. A machine according to claim 7, arranged in such a manner that a component of a current that flows in a coil to produce a gradient is proportional to a nominal current multiplied by the cosine of an angle that identifies the coil on the perimeter of the annular space.

9. A machine according to any one of claims 1 to 5, **characterized in that** the annular space (130) includes several contiguous tubes distributed at the perimeter to receive the solenoidal coils, the radius a of a tube being given by $a = r1(\sin\pi/N)/(1-\sin\pi/N) = r2(\sin\pi/N)/(1+\sin\pi/N)$, in which formula N represents the number of tubes and r1 and r2 the inside and outside radii, respectively, of the annular space (130).

10. A machine according to any one of claims 1 to 9, arranged in such a manner that the solenoidal coils are energized by individual electrical power supplies.

11. A machine according to any one of claims 1 to 10, **characterized in that** the solenoidal coils are formed of elongate helicoidal turns, preferably of rectangular profile, along circular conductive sleeves, sleeves of the same coil being concentric and engaged one within another.

12. A machine according to claim 11, **characterized by** an annular space between two sleeves for a cooling fluid.

**Patentansprüche**

1. Kernspinresonanzmaschine, umfassend Mittel (101) zum Erzeugen eines starken magnetischen Hauptfeldes $B_0$ in einem tunnelförmigen Nutzinnenraum (109) mit der Achse Z, Mittel zur Radiofrequenzerregung und zur Verarbeitung der durch einen Körper (150) oder ein Objekt, der bzw. das in dem Nutzinnenraum (109) angeordnet ist, als Reaktion ausgesandten Radiofrequenzsignale, sowie eine erste Anordnung (110, 210) von Solenoid-Gradientenspulen, um dem starken Magnetfeld $B_0$ Komponenten eines zusätzlichen Magnetfeldes zu überlagern, wobei die Gradientenspulen (111-122; 211-222) in Röhren eingesetzt sind, die parallel zur Z-Achse in einem zylindrischen Ringraum (130) angeordnet sind, welcher zwischen einem die Mittel (101) zum Erzeugen eines starken Magnetfeldes $B_0$

enthaltenden kryogenen Außenraum (102) und dem Nutzinnenraum (109) gelegen ist, wobei der Durchmesser der Gradientenspulen (111-122; 211-222) innerhalb einer Dicke des zylindrischen Ringraums (130) liegt, wobei die Solenoid-Gradientenspulen (111-122; 211-222) der ersten Anordnung (110) dafür ausgelegt sind, sowohl einen ersten Feldgradienten X in einer ersten radialen Richtung x der Maschine, welche zu der Z-Achse senkrecht verläuft, als auch einen zweiten Feldgradienten Y in einer zweiten radialen Richtung y der Maschine, welche ebenfalls zu der Z-Achse senkrecht verläuft, zu erzeugen, wobei die erste Richtung x zu der zweiten Richtung y senkrecht verläuft, und wobei die Maschine Verstärker (45, 59) umfaßt, um diese Solenoidspulen gleichzeitig mit algebraischen Summen von Strömen, die den beiden Gradienten entsprechen, zu versorgen, und wobei der zylindrische Ringraum (130) an einer Außenwand (108) dessen ringförmige Spulen zum Erzeugen eines Magnetfeldgradienten Z, der parallel zur Richtung des Hauptmagnetfeldes $B_0$ ausgerichtet ist, umfaßt, während die Solenoidspulen (111,122; 211-222) der ersten Anordnung alle in der Dicke des zylindrischen Ringraums (130) angeordnet sind, **dadurch gekennzeichnet, daß** die in Röhren eingesetzten Solenoid-Gradientenspulen (211 bis 222) Einzelquellen von Feldgradienten X und Y in den Richtungen x und y bilden, die als zu einer Anordnung von benachbarten, entlang dem Umfang des zylindrischen Ringraums verteilten N Einzelquellen gehörend ausgelegt sind, wobei N = 4u + 2, wobei u eine ganze Zahl größer oder gleich 1 ist, wobei aber zwei diametral gegenüberliegende Einzelquellen, die einer Axialebene xOz entsprechen, weggelassen sind, um nur 4u benachbarte Einzelquellen, die in zwei durch Freiräume getrennte Untereinheiten (211-216, 217-222) aufgeteilt sind, zu behalten, wobei jede Röhre mit einer Einzelquelle versehen ist.

2. Maschine nach Anspruch 1, **dadurch gekennzeichnet, daß** sie ferner zwischen dem kryogenen Außenraum (102) und dem zylindrischen Ringraum (130) einen zusätzlichen zylindrischen Ringraum (330) umfaßt, in dem eine zweite Anordnung (310) von Solenoid-Gradientenspulen angeordnet ist, welche in parallel zur Z-Achse angeordneten Röhren eingesetzt sind, wobei die zweite Anordnung derart angeordnet ist, daß die Zirkulationsrichtung der gepulsten Ströme in den Solenoid-Gradientenspulen (311 bis 322) der zweiten Anordnung (310) zu der Zirkulationsrichtung der gepulsten Ströme in den Solenoid-Gradientenspulen (111 bis 122) der ersten Anordnung (110) umgekehrt ist, um Feldgradienten in umgekehrter Richtung zu erzeugen, die das Vektorpotential sowie die Wirbelströme, welche in dem kryogenen Außenraum (102) induziert werden, reduzieren.

3. Maschine nach Anspruch 2, **dadurch gekennzeichnet, daß** die Anzahl der in alle Röhren der zweiten Anordnung (310) eingesetzten Solenoid-Gradientenspulen (311 bis 322) mit der Anzahl der in alle Röhren der ersten Anordnung (110) eingesetzten Solenoid-Gradientenspulen (111 bis 122) identisch ist.

4. Maschine nach Anspruch 2, **dadurch gekennzeichnet, daß** die Anzahl der in alle Röhren der zweiten Anordnung (310) eingesetzten Solenoid-Gradientenspulen (311 bis 322) von der Anzahl der in alle Röhren der ersten Anordnung (110) eingesetzten Solenoid-Gradientenspulen (111 bis 122) abweicht.

5. Maschine nach einem der Ansprüche 2 bis 4, **dadurch gekennzeichnet, daß** der zusätzliche zylindrische Ringraum (330) an einer Außenwand (103) dessen ringförmige Ausgleichsspulen umfaßt, die angeordnet sind, um einen Magnetfeldgradienten Z, der in der Richtung des Hauptmagnetfeldes $B_0$ ausgerichtet ist, zu erzeugen, während die Solenoidspulen (311-322) der zweiten Anordnung (310), die Feldgradienten X, Y in den Richtungen x und y erzeugen, alle in der Dicke des zusätzlichen zylindrischen Ringraums (330) angeordnet sind.

6. Maschine nach einem der Ansprüche 1 bis 5, **dadurch gekennzeichnet, daß** die Solenoidspulen (111-122; 211-222) der ersten Anordnung (110; 210) entlang dem Umfang des Ringraums (130) in 2n Anordnungen von koaxialen Solenoidspulen, wobei n eine ganze Zahl größer oder gleich 3 ist, aufgeteilt sind, und gegebenenfalls die Solenoidspulen (311-322) der zweiten Anordnung (310) entlang dem Umfang des zusätzlichen zylindrischen Ringraums (330) in 2n Anordnungen von koaxialen Solenoidspulen, wobei n eine ganze Zahl größer oder gleich 3 ist, aufgeteilt sind.

7. Maschine nach einem der Ansprüche 1 bis 5, **dadurch gekennzeichnet, daß** die Solenoidspulen (111-122; 211-222) der ersten Anordnung (110; 210) entlang dem Umfang des Ringraums (130) in 2n Anordnungen von koaxialen Solenoidspulen, wobei n eine ganze Zahl größer oder gleich 3 ist, aufgeteilt sind, und gegebenenfalls die Solenoidspulen (311-322) der zweiten Anordnung (310) entlang dem Umfang des zusätzlichen zylindrischen Ringraums (330) in 2n Anordnungen von koaxialen Solenoidspulen aufgeteilt sind, wobei die Verstärker angeordnet sind, um mehrere Spulen durch Kombinationen von Strömen gleichzeitig zu versorgen, um einen Gradienten X und Y zu erzeugen, wobei n eine ganze Zahl größer oder gleich 3 ist.

8. Maschine nach Anspruch 7, die derart angeordnet ist, daß eine Komponente eines Stroms, der in einer Spule fließt, um einen Gradienten zu erzeugen, proportional zu einem Nennstrom multipliziert mit einem Kosinus eines Markierungswinkels der Spule auf dem Umfang des Ringraums ist.

9. Maschine nach einem der Ansprüche 1 bis 5, **dadurch gekennzeichnet, daß** der Ringraum (130) mehrere über den Umfang verteilte benachbarte Röhren umfaßt, um die Solenoidspulen aufzunehmen, wobei der Radius a einer Röhre durch $a = r1 (\sin\pi/N)/(1- \sin\pi/N) = r2(\sin\pi/N)/(1+ \sin\pi/N)$ angegeben ist, Formel, worin N die Anzahl der Röhren sowie r1 und r2 den Innen- bzw. den Außenradius des Ringraums (130) darstellt.

10. Maschine nach einem der Ansprüche 1 bis 9, die derart angeordnet ist, daß Solenoidspulen durch Einzelstromversorgungen gespeist werden.

11. Maschine nach einem der Ansprüche 1 bis 10, **dadurch gekennzeichnet, daß** die Solenoidspulen von länglichen schraubenförmigen Windungen, vorzugsweise mit rechteckigem Profil, entlang von leitenden kreisförmigen Manschetten gebildet sind, wobei mehrere Manschetten einer gleichen Spule konzentrisch und ineinander gesteckt sind.

12. Maschine nach Anspruch 11, **dadurch gekennzeichnet, daß** ein Ringraum zwischen zwei Manschetten von einem Kühlmittel durchströmt wird.

FIG.1

FIG.2

FIG.3

FIG.4

FIG.5

## RÉFÉRENCES CITÉES DANS LA DESCRIPTION

**Documents brevets cités dans la description**

- FR 2588997
- FR 2621125
- WO 2005029110 A
- US 5530355 A
- US 5764059 A